# EUROPEAN PATENT SPECIFICATION

(11) **EP 0 732 039 B1**
(45) Date of publication and mention of the grant of the patent: **17.10.2001**
(21) Application number: 94903396.3
(22) Date of filing: 02.12.1993
(51) Int. Cl.: H05K 3/00

(54) **FABRICATION MULTILAYER COMBINED RIGID/FLEX PRINTED CIRCUIT BOARD**
HERSTELLUNG EINER KOMBINIERTEN STARREN/FLEXIBLEN MEHRSCHICHTIGEN LEITERPLATTE
FABRICATION DE PLAQUETTES A CIRCUITS IMPRIMES A COUCHES MULTIPLES RIGIDES/FLEXIBLES COMBINEES

(43) Date of publication of application: 18.09.1996
(73) Proprietor: TELEDYNE INDUSTRIES, INC., Los Angeles, CA 90067-3101 (US)
(72) Inventor: MILLETTE, Lee, J., Litchfield, NH 03051 (US); CARON, A., Roland, Hudson, NH 03051 (US); THOMAN, Joseph, A., Manchester, NH 03104 (US)
(74) Representative: Dubois-Chabert, Guy
(86) International application number: US9311684
(87) International publication number: WO9515673

(56) References cited:
- EP-A- 0 348 632
- GB-A- 2 249 219
- US-A- 4 800 461
- US-A- 5 144 742
- DATABASE WPI Week 8743, Derwent Publications Ltd., London, GB; AN 87-304117 & JP,A,62 214 939 (MATSUSHITA ELEC WORKS) 21 September 1987
- PATENT ABSTRACTS OF JAPAN vol. 14, no. 528 (E-1004)20 November 1990 & JP,A,02 224 294 (SHIN KOBE ELECTRIC MACH CO) 6 September 1990

## Description

### Background of the Invention

### Field of the Invention

The present invention relates to the fabrication of multilayer combined rigid and flex printed circuits having flexible printed circuits extending from the rigid board. In particular, the present invention relates to an improved process for the fabrication of multilayer combined rigid and flex printed circuits, wherein two circuit boards having rigid and flexible sections can be prepared from a novel basestock composite.

### Background of the Invention

Techniques for making multilayer rigid flex printed circuit boards are well known in the art. One early example of the prior art is disclosed in U.S. Patent No. 3,409,732, assigned to the Assignee of the present application and whose teachings are incorporated by reference. Typically a rigid flex stacked printed circuit board includes flexible printed circuit cables extending from the periphery of the rigid section or sections. The rigid portions of the flex cables are typically used as sites for electronic components or mechanical hardware. It is important to note that the copper conductor in each plane or layer is fabricated from one continuous sheet of copper foil.

With improvements in electronic technology, there has been a constant need for advances in electronic packaging. This need has led to more complex multilayer rigid flex printed circuit boards with many boards now using up to twenty-five, or even more, layers of circuitry. However, severe problems developed when the rigid circuit portions included many layers of conductors and holes plated through with copper to provide conductor barrels connecting the conductor layers.

One particular problem, reported on and discussed in U.S. Patent No. 4,800,461, assigned to the assignee of the present Application, and whose teachings are incorporated by reference, described the fact that in multilayer rigid flex boards which included insulator materials such as acrylic adhesive and Kapton (Kapton is a trademark of E.I. duPont de Nemours and Company Inc. for polyimide film), the insulating materials placed a "Z-axis" stress on plated through holes. The coefficient of thermal expansion, it was reported, of the acrylic adhesive (Z-axis expansion) was the dominate influence. It was observed that because of the amount of acrylic required in many multilayer rigid flex applications, all plated through holes are stressed, with many cracking, making the boards unusable.

To overcome this problem, the '461 patent reported on a novel process to provide a rigid section incorporating insulator materials which, when subjected to elevated temperatures, did not: expand in the Z direction to cause difficulties, including delamination and cracking of plated copper barrels. Stated another way, in the '461 patent,the materials causing undesirable expansion in the Z direction in the multilayer rigid section of the board, and the materials absorbing excessive amounts of moisture, such as acrylic adhesives and Kapton, were eliminated from the boards rigid section.

However, although the '461 patent was extremely successful in addressing the various problems recited therein, and in particular, the problem of thermal stresses described above, the process for fabrication of the rigid flex printed circuits has remained limited to the fabrication of a multilayer combined rigid and flex printed circuit board wherein two circuit boards are always prepared from a basestock composition, and remain attached to one another via the prepreg. In other words, the process of fabrication according to the teachings of

the prior art begin with the step of laminating two conductor layers (i.e. copper layers) to a single insulator layer (prepreg) followed by imaging and etching. Accordingly if one of the two bonded conductor layers was somehow improperly imaged, it was necessary to discard the entire lamination.

GB-A-2 249 219 discloses a printed circuit base stock composite and a method for the fabrication thereof, wherein two single-sided copper-clad laminates are bonded together by means of a double-sided adhesive tape. Then, after imaging and etching the copper layers to form conductor patterns, the two single-sided printed wiring boards are separated from each other.

It is an object of this invention to provide a process for the fabrication of a multilayer combined rigid and flex printed circuits, wherein two circuit boards having rigid and flex sections can be prepared and imaged from a novel basestock composite, followed by separation into two individual single sided basestock laminates.

It is also an object of this invention to provide a novel basestock composition of sufficient planarity and rigidity to permit adequate handling and further processing thereof, and which can be separated into two individual layers each comprising an imaged copper layer laminated to a fiberglass sheet which is impregnated with adhesives such as an epoxy.

### Summary of the Invention

The present invention provides a process for the fabrication of a rigid flex printed circuit as defined in claim 1 and a rigid flex printed circuit basestock composite as defined in claim 14. Two copper sheets are laminated to a prepreg and in-between said laminated copper sheets is placed a release material that is not coextensive with the boarders of the prepreg, such that the basestock can be imaged and processed in the usual manner, and such that cutting the edges of the basestock material, after imaging, at a location internal to the basestock border provides a cut into the release layer, thereby allowing for separation of the two individual imaged copper layers and their supporting prepreg, along with the removal of said release material.

The present invention also comprises in process form, a process for the fabrication of a rigid flex printed circuit comprising the steps of laminating a pair of conductor layers to respective opposite surfaces of an insulating layer wherein the insulator layers are both affixed to a release layer and wherein said release layer is not coextensive with the borders of the insulator layers, thereby forming a basestock composite. The basestock composite is then imaged and etched on the conductor layers to form conductor patterns. The basestock is then cut: at a point internal to its borders and into the release layer thereby separating the two imaged and etched conductor layers and removing said release material from the insulating layer.

### Brief Description of the Drawings

The foregoing and other features and advantages of the present invention will be more readily understood and will become apparent from the following detailed description taken in conjunction with the drawings, in which:
Fig. 1 is an exploded view of the novel basestock composite.
Fig. 2 is an exploded view of the novel basestock composite showing it cut at a point internal to its borders and into the release layer.
Fig. 3 is an exploded view of the novel basestock composite with a prepreg and Kapton/acrylic covercoat.
Fig. 4 is an exploded view of a single conductor layer used to fabricate a multilayer combined rigid and flex printed circuit.
Fig. 5 is a view in perspective of the layers of Fig. 4 following lamination and certain processing steps.
Fig. 6 is a cross section taken along view line 3-3 in Fig. 5 and enlarged for clarity.
Fig. 7 is a perspective view diagrammatically showing the inventive rigid flex circuits following lamination and other processing steps of the structures shown in Figs. 5 and 6.
Fig. 8 is an exploded view of the sheet materials used to form the layers of structures forming the inventive rigid flex circuits, wherein the basestock contain two laminated copper sheets without a release layer.
Fig. 9 is a view in perspective of the layers of Fig. 8 following lamination and certain processing steps.
Fig. 10 is a cross section taken along view line 3-3 in Fig. 9 and enlarged in the interests of clarity.
Fig. 11 is a perspective view diagrammatically showing the inventive rigid flex circuits following lamination and other processing steps of the structures shown in Figs. 9 and 10.

### Detailed Description of the Invention

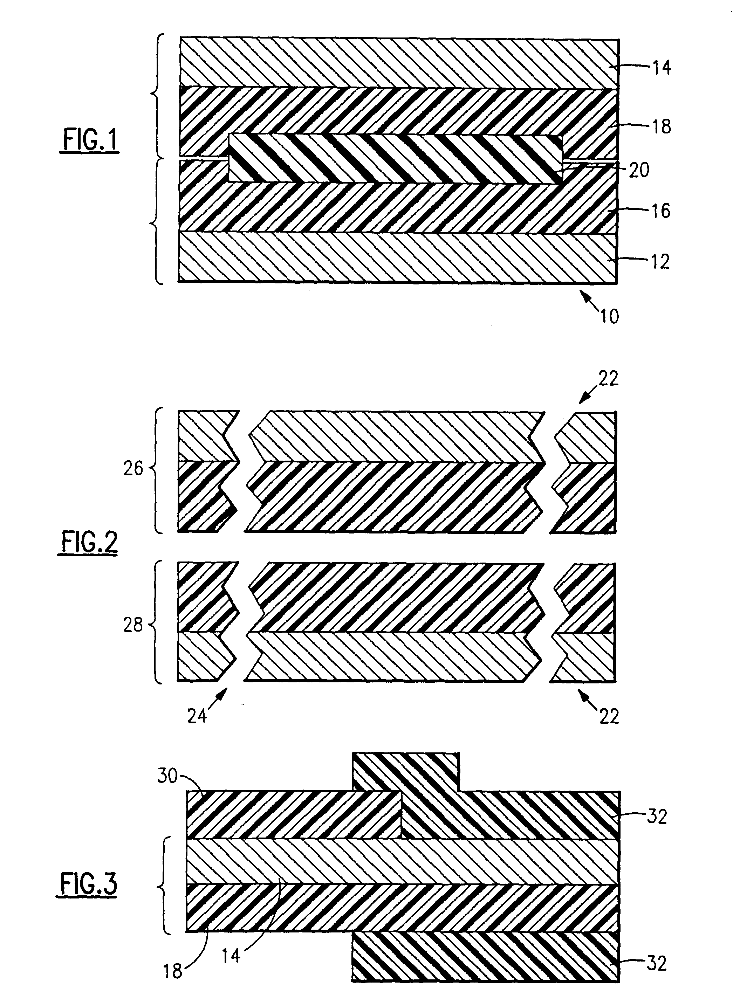

In the first exemplary embodiment of the invention shown in Fig. 1, the novel basestock composite 10 is shown to comprise two copper conducting sheets 12 and 14, for example, one or two ounce copper, bonded to insulator layers 16 and 18 comprised of fiberglass sheets impregnated with an adhesive such as epoxy, and commonly referred to as prepreg. Also shown in Fig. 1 is the release material 20 and the release material is shown as not being coextensive with the borders of the insulating layers 16 and 18.

Accordingly, it can be appreciated that in the method of preparation of the novel basestock composite 10, a pair of conducting sheets or layers, 12 and 14, are laminated to the opposite surfaces of insulating layers 16 and 18, wherein the insulating layers are both affixed to a release layer 20 and wherein said release layer is not coextensive with the borders of the insulating layers. It can be appreciated that the basestock composite comprising the pair of conducting sheets has sufficient planarity and rigidity to permit handling and further processing thereof, and in particular, imaging to form conductor patterns.

Turning then to Fig. 2, the basestock composite which has been imaged and etched to form conductor patterns 22, is cut at a point internal to its borders 24 and into and through the release layer 20 and the two conductor layer patterns 26 and 28 are separated and the release material is removed from the insulating layers. Each conductor layer can then be further processed, as described below.

Figure 3 shows one of the separated conductive layers 14 and its adjacent prepreg 18 further covered with another prepreg layer covercoat 30 and a flexible insulating layer of a Kapton/acrylic covercoat 32. Alternatively, the Kapton/acrylic covercoat 32 can be replaced with a less expensive photoimagable solder mask.

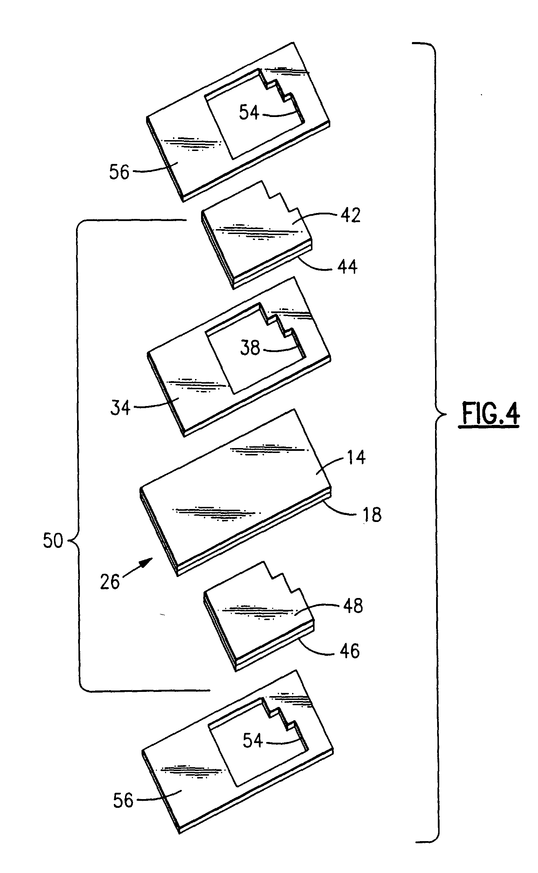

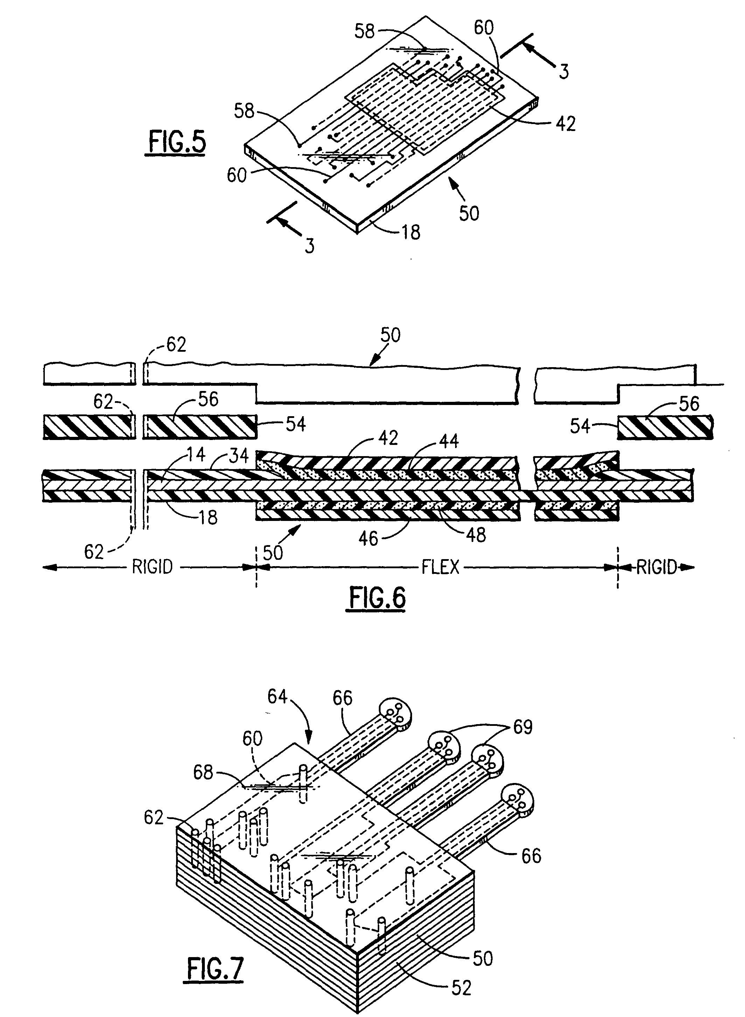

In an exemplary embodiment of the invention shown in Figs. 4-7, the formation of the multilayer rigid flex printed circuits begins with supplying a conductor pattern 26 or 28 followed by an initial processing step which includes treating the exposed copper conductor patterns to enhance bondability of another epoxy prepreg to the copper, for example, by the black oxide process typically used in the rigid board field. One additional insulator prepreg sheets 34, having cutout 38, is positioned on one side of the base stock 26. A flexible insulator of Kapton 42, covered with a layer of suitable adhesive 44, for example, an acrylic adhesive which provides excellent bonding of Kapton to copper, is positioned on one side of the glass sheet 34. A similar sheet of Kapton 46 covered with a layer of adhesive 48 is located on the other side of the glass sheet 26. Insulator layers such as Kapton and acrylic adhesive afford flexibility and tear resistance characteristics to the flex sections, as discussed in connection with Figs. 6 and 7. Alternatively, the Kapton 46 and adhesive 48 can be replaced with a photoimagable solder mask.

As shown in Fig. 6, the Kapton sheets 42 and 46 and their associated adhesive layers 44 and 48 are slightly longer than the length of the cutouts 38 and 40 in the glass layers to overlap slightly the sheet 34 by, for example 0.050 inch (1 inch = 25,4 mm). The sandwich formed by the foregoing sheets is then laminated together to provide the printed circuit structure 50 shown in Figs. 4 and 5. Note that in the interests of clarity, the sides of the cutouts are not shown in Fig. 7.

After lamination processing, a number of the printed circuits 50 are stacked in proper registration with epoxy impregnated fiberglass layers 52 (Fig. 7) positioned between, for example, seven of the circuits 50. For clarity, only two of the printed circuit structures 50 are shown with the upper circuit 50 illustrated diagrammatically and broken away.

Note that cutouts 54 in the prepreg sheets 56 are slightly longer than the cutouts 38 (Fig. 4) and coextensive with the Kapton layers 42 and 46 so that the Kapton layers 42 and 46 abut the edges of the sheets 56, as shown in Fig. 7.

Prior to stacking the circuits 50, it is desirable to cut the flex cables, shown in Fig. 7, that extend through the cutout areas, to simplify the final construction of the rigid flex printed circuit structure.

After stacking seven of the circuits 50 with appropriate outer caps, the layers are laminated to provide, in this example, a nine layer rigid flex circuit (the outer caps add in this example one layer per cap), and holes are then drilled at appropriate pads 58 to interconnect desired conductors 60. The holes are then desmeared by a suitable process, for example, exposing them to appropriate cleaning chemicals to expose fully the copper conductors, a rapid process due to the absence of any adhesives or insulating material resistant to such chemicals, such as acrylics and. Kapton, in the rigid circuit portion. If desired, plasma desmearing techniques can be used instead of chemical cleaning.

The holes are then plated through to interconnect desired conductors 60, a portion of a plated-through barrel 62 being shown in broken lines in Fig. 6, because it will not be formed until after lamination of the circuits 50 with the prepreg layers 56.

Referring next to Fig. 7, which shows somewhat diagrammatically a rigid flex circuit 64 with the plated through holes 62 enlarged, in the interests of clarity, flex cables 66 coextensive with the rigid and flex sections, and extending between the rigid sections 68 and 69 for suitably connecting the printed circuits. If desired, upper and lower caps are laminated to the circuits 50 in the rigid board area 68 only. Such caps typically are fabricated using polyimide glass or epoxy glass copper-clad laminates. Copper conductor circuits can be formed on one or both sides of the caps, as desired.

With the rigid section 68, and the portions of the flex cables coextensive with the rigid section, formed by an insulator material, i.e., layers of fiberglass and adhesive, such as epoxy, which have characteristics or properties which allow the rigid board portion to relieve stresses, caused by heating, in the board, delamination of the circuits and cracking of the plated through barrels is prevented when the board, or portions thereof, is subjected to elevated temperatures.

In other words, the rigid board 68 does not contain troublesome materials, such as acrylic adhesive and Kapton, having high expansion rates and moisture absorption properties, because the flex cable sections including Kapton and acrylic adhesive only extend to but not substantially into the rigid section. Of course the Kapton and acrylic layers could extend an insubstantial distance into the rigid section without causing undue problems. Further, subjecting the inventive circuits to hot solder reflow and elevated temperatures will not cause differential expansion and contraction leading to cracking of the copper plated through barrels 62 or delamination of the layers. Moreover, extended baking times at temperatures on the order of 250°F., often as long as 48 hours, to remove moisture, are avoided. Additionally, and advantageously, use of release and/or carrier board materials in the base stock portion of the inventive board permits increased rigidity and better handling characteristics of thereof.

While the invention enables the successful fabrication of multilayer rigid flex boards having a great number of conductor layers, the invention also provides excellent multilayer rigid flex boards having fewer layers, for example on the order of as few as four conductor layers.

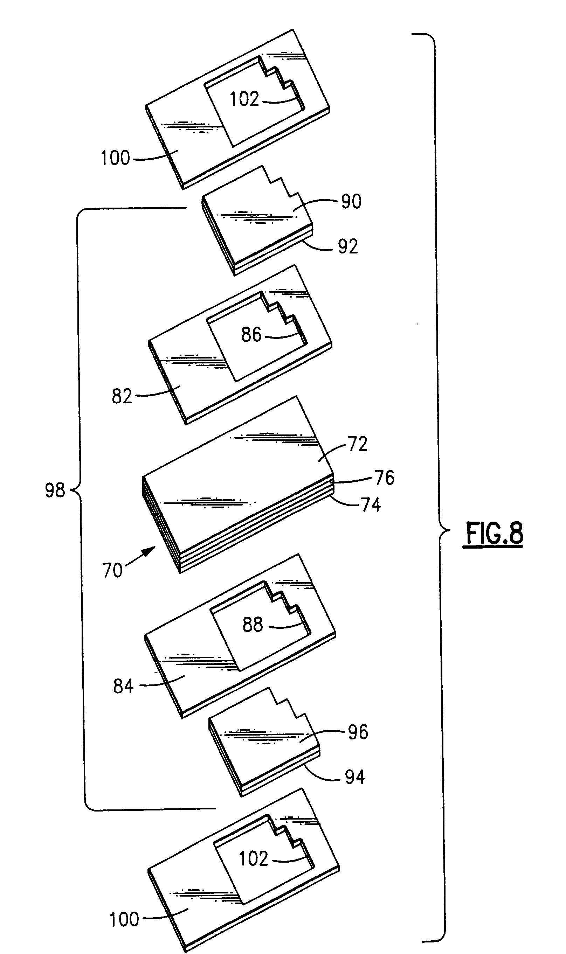

In the second exemplary embodiment of the invention shown in Figs. 8-11, the initial processing step includes forming base stock 70 by laminating two copper sheets 72 and 74, for example one or two ounce copper, to an insulator layer 76 comprised of one or two fiberglass sheets impregnated with an adhesive such as epoxy,commonly referred to as prepreg. While two layers of glass have been shown, in order to provide at least 3.5 mils between the copper planes after lamination, for meeting military specifications, a single sheet of prepreg may be used in appropriate circumstances.

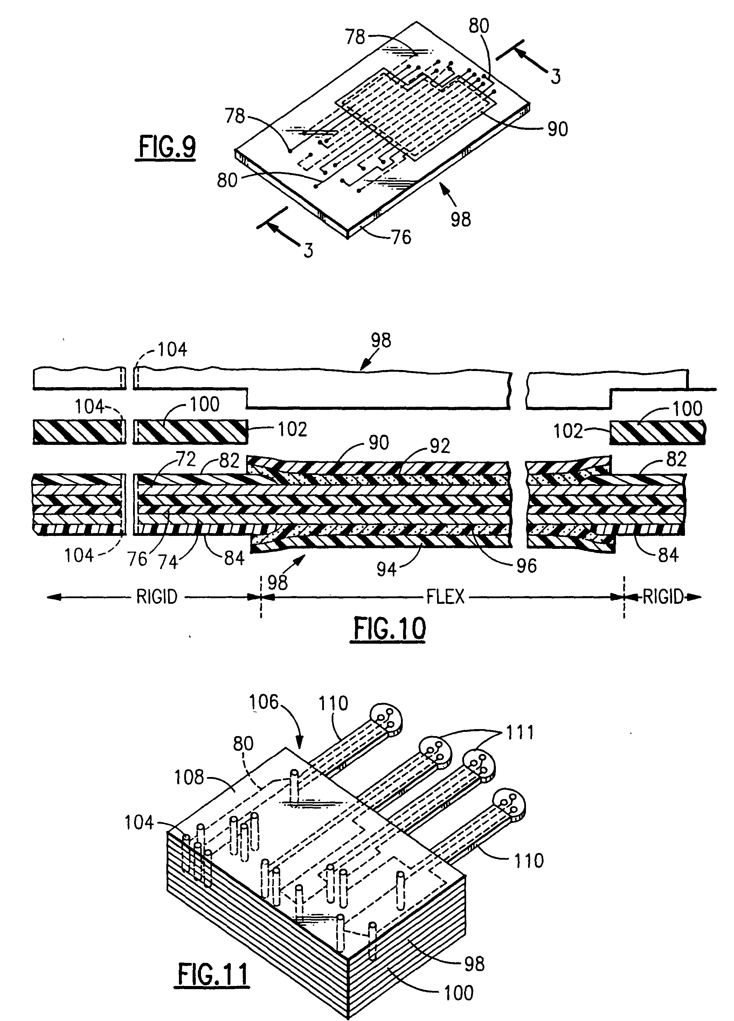

Following lamination of the base stock 70, the copper layers are imaged and etched to provide copper pads 78 and conductors 80 (shown diagrammatically in Fig. 9) on the glass layer 76. Exposed copper conductor patterns are then treated to enhance bondability of the epoxy prepreg to the copper, for example by the black oxide process typically used in the rigid board field.

Two additional insulator prepreg sheets 82 and 84 having cutouts 86 and 88, are positioned on both sides of the base stock 70. A flexible insulator of Kapton 90, covered with a layer of a suitable adhesive 92, for example an acrylic adhesive which provides excellent bonding of Kapton to copper, is positioned on one side of the glass sheet 82. A similar sheet of Kapton 92 covered with a layer of adhesive 96 is located on the other side of the glass sheet 84. Insulator layers such as Kapton and acrylic adhesives afford excellent flexibility and tear resistance characteristics to the flex sections, as discussed in connection with Figs. 10 and 11.

As shown in Fig. 10, the Kapton sheets 90 and 94 and their associated adhesive layers 92 and 96 are slightly longer than the length of the cutouts 86 and 88 in the glass layers to overlap slightly the sheets 82 and 84 by, for example 0.050 inch. The sandwich formed by the foregoing sheets is then laminated together to provide the printed circuit structure 98 shown in Figs. 9 and 10. Note that in the interests of clarity, the sides of the cutouts 86 and 88 are not shown in Fig. 10.

After lamination processing, a number of the printed circuits 98 are stacked in proper registration with epoxy impregnated fiberglass layers 100 (Fig. 10) positioned between, for example, seven of the circuits 98. For clarity, only two of the printed circuit structures 98 are shown with the upper circuit 98 illustrated diagrammatically and broken away.

Note that cutouts 102 in the prepreg sheets 100 are slightly longer than the cutouts 86 and 88 (Fig. 8) and coextensive with the Kapton layers 90 and 94 so that the Kapton layers 90 and 94 abut the edges of the sheets 100, as shown in Fig. 10.

Prior to stacking the circuits 98, it is desirable to cut the flex cables, shown in Fig. 11, that extend through the cutout areas, to simplify the final construction of the rigid flex printed circuit structure.

After stacking seven of the circuits 98 with appropriate outer caps, the layers are laminated to provide, in this example, a sixteen layer rigid flex circuit (the outer caps add in this example one layer per cap), and holes are then drilled at appropriate pads 78 to interconnect desired conductors 80. The holes are then desmeared by a suitable process, for example, exposing them to appropriate cleaning chemicals to expose fully the copper conductors, a rapid process due to the absence of any adhesives or insulating material resistant to such chemicals, such as acrylics and Kapton, in the rigid circuit portion. If desired, plasma desmearing techniques can be used instead of chemical cleaning.

The holes are then plated through to interconnect desired conductors 80, a portion of a plated-through barrel 104 being shown in broken lines in Fig. 10, because it will not be formed until after lamination of the circuits 98 with the prepreg layers 100.

As discussed above, problems of thermal expansion and moisture retention in the rigid section, which have been encountered in the past with materials such as Kapton and acrylic adhesives, are avoided by the absence of such materials.

Referring next to Fig. 11, which shows somewhat diagrammatically a rigid flex circuit 106 with the plated through holes 104 enlarged, in the interests of clarity, flex cables 110 coextensive with the rigid and flex sections, and extending between the rigid sections 108 and 112 for suitably connecting the printed circuits. If desired, upper and lower caps are laminated to the circuits 98 in the rigid board area 108 only. Such caps typically are fabricated using polyimide glass or epoxy glass copper-clad laminates. Copper conductor circuits can be formed on one or both sides of the caps, as desired.

With the rigid section 108, and the portions of the flex cables coextensive with the rigid section, formed by an insulator material, i.e. layers of fiberglass and an adhesive, such as epoxy, which have characteristics or properties which allow the rigid board portion to relieve stresses, caused by heating in the X and Y plane of the board, delamination of the circuits and cracking of the plated through barrels is prevented when the board is subjected to elevated temperatures.

In other words, the rigid board 108 does not contain troublesome materials, such as acrylic adhesive and Kapton, having high expansion rates and moisture absorption properties, because the flex cable sections including Kapton and acrylic adhesive only extend to but not substantially into the rigid section. Of course, the Kapton and acrylic layers could extend an insubstantial distance into the rigid section without causing undue problems. Subjecting the inventive circuits to hot solder reflow and elevated temperatures will not cause differential expansion and contraction leading to cracking of the copper plated through barrels 104 or delamination of the layers. Moreover, extended baking times at temperatures on the order of 250°F, often as long as 48 hours, to remove moisture, are avoided.

While the invention enables the successful fabrication of multilayer rigid flex boards having a great number of conductor layers, the invention also provides excellent multilayer rigid flex boards having fewer layers, for example, on the order of as few as four conductor layers.

While the invention has been shown and described with reference to the above described embodiments, which provide rigid flex circuits affording advantages not found in prior art printed circuits, it will be understood that various changes may he made without departing from the scope of the invention as defined in the appended claims. For example, imaging and connection of the conductors of the circuits may be accomplished by covering the whole board with a layer of photoimagable solder mask to permit the whole board to be processed at once. Advantageously, this greatly reduces the costs of performing this processing step, and thus, reduces the overall cost of the resulting board.

## Claims

1. A process for the fabrication of a rigid flex printed circuit comprising the steps of
laminating a pair of conductor layers (12,14) to respective opposite surfaces of a pair of insulting layers, wherein the insulator layers (16,18) are affixed to opposite surfaces of a release layer (20), and wherein said release layer is not coextensive with the borders of the insulating layers, thereby forming a base stock composite (10);
imaging and etching said conductor layers to form conductor patterns (22);
cutting the basestock composite at a point internal to the borders of said composite and into the release layer;
separating the two imaged and etched conductor layers and removing said release material from the insulating layer.

2. A process for the fabrication of rigid flex printed circuit boards as defined in claim 1, wherein said release material is poly(vinyl fluoride).

3. A process for the fabrication of rigid flex printed circuit boards as defined in claim 1, wherein the insulating layers are fiberglass layers impregnated with an epoxy adhesive.

4. A process for the fabrication of circuit boards as defined in claim 1, comprising the additional steps of
laminating to said separated imaged and etched conductor layer a pair of first insulator layers impregnated with an adhesive having cutout portions and
insulator sheets covered on one side with an adhesive layer coextensive with the cutout portion and slightly overlapping at least one edge of the first insulator layers so as to form a first printed circuit structure containing one conductor layer, cutting suitable flex cables in the cutout portion area, stacking a plurality of the first printed structures with second insulator layers impregnated with adhesive interposed between said first circuit structure, the second insulator layers having cutout sections generally coextensive with the insulator sheets, laminating the first printed circuit structures and the second insulator layers together to form a second printed circuit structure having rigid and flexible portions, drilling holes in the rigid section of the printed circuit structure, cleaning the holes, and plating through the holes to form conductive barrels connecting conductors in the conductor patterns of the conductor layers, whereby the second printed circuit structure is a rigid flex circuit having flexible cables cut from the areas coextensive with the cutout portions and extending from the rigid section.

5. A process according to claim 4, wherein the insulator sheets in the rigid section are fiberglass layers impregnated with an epoxy adhesive, and the insulator sheets covered on one side with an adhesive layer are of polyimide film layers covered on one side with an acrylic adhesive.

6. A process according to claim 5, wherein the insulator sheets covered on one side with an adhesive is replaced with a photoimagable solder mask.

7. A process according to claim 1, comprising the further steps of
laminating to the imaged and etched conductor layer a pair of first conductor layers impregnated with adhesive having cutout portions, and insulator sheets covered on one side with an adhesive layer coextensive with the cutout portion and slightly overlapping at least one edge of the first insulating areas, so as to form a first printed circuit structure containing one conductor layer, cutting suitable flex cable in the cutout portion area, stacking a plurality of the first printed circuit structures with second insulator layers impregnated with adhesive interposed between said first circuit structures, the second insulator layers having cutout sections generally coextensive with the insulator sheets, laminating the first printed circuit structures and the insulator layers together to form a second printed circuit structure having rigid and flexible section, drilling holes in the rigid section of the printed circuit structure, cleaning the holes and plating through the holes to form conductive barrels connecting conductors in conductor patterns of the conductor layers, whereby the second printed circuit structure is a rigid flex circuit having flexible cables cut from the areas coextensive with the cutout portions and extending from the rigid section.

8. A process as defined in claim 7, wherein the insulator sheets in the rigid section are fiberglass layers impregnated with an epoxy adhesive, and the insulator sheets covered on one side with an adhesive layer in the flexible section are of polyimide film layers carrying acrylic adhesive layers.

9. The process of claim 8, wherein the insulator sheets covered on one side with an adhesive layer is replaced with a photoimagable solder mask.

10. A process according to claim 1, comprising the further steps of :
laminating to the imaged and etched conductor layer a first pair of layers of rigid section insulator material each having a portion removed therefrom to form a cutout which corresponds to the circuit board area to be made flexible, a pair of sheets of flexible section insulator material which are coextensive with the cutouts in the rigid section insulator layers and slightly overlapped a respective rigid section insulator layer at an edge of the cutout therein, so as to form a first printed circuit structure containing one conductor layer;
cutting the sheets of flexible section material and first insulator layer to form at least one flexible cable at least partially coextensive with the cutouts in said rigid section insulator layers.

11. A process for fabrication of printed circuit boards as defined in claim 10, and wherein, said process includes the additional steps of:
stacking a plurality of said first circuit structures with interposed layer of rigid section insulator material positioned coextensive with rigid sections which are to be further laminated rigid sections;
laminating said plurality of stacked first printed circuit structures and interposed insulator layers to form a second printed circuit structure having rigid and flexible sections;
drilling holes in the rigid sections of said second printed circuit structures; and
plating through said holes to form conductive barrels connecting conductors in the conductor patterns.

12. A process for fabrication of circuit boards as defined in claim 10, wherein said rigid section insulator material is fiberglass impregnated with a thermally-activatable epoxy adhesive, and said flexible section insulator material is polyimide film covered on one side with an acrylic adhesive.

13. The process of claim 12, wherein the insulator sheets covered on one side with an adhesive layer is replaced with a photoimagable solder mask.

14. A rigid flex printed circuit basestock composite which allows for the preparation of two rigid flex circuit boards that can be separated into two individual basestock composites, after imaging, comprising
a pair of conductive layers (12,14) laminated to respective opposite surfaces of a pair of insulating layers, wherein the insulator layers (16,18) are affixed to opposite surfaces of a release layer (20), and wherein said release layer is not coextensive with the borders of the insulating layers, thereby forming a basestock composite;
conductor patterns formed by imaging and etching said conductor layers;
the composite being suitable to be cut at a point internal to the borders of said composite and into the release layer and for subsequent;
separation of the two imaged and etched conductor layers and removing said release material from the insulating layers.

15. The rigid flex basestock composite of claim 14 wherein the release layer is poly(vinyl fluoride).

16. The rigid flex basestock composite of claim 14 wherein the insulating layers are fiberglass layers impregnated with an epoxy adhesive.

## Patentansprüche

1. Verfahren zur Herstellung einer Leiterplatte mit starren und biegsamen Abschnitten, das folgende Schritte umfaßt:
Auflaminieren zweier Leiterschichten (12,14) auf die jeweils entgegengesetzten Oberflächen zweier Isolierschichten, wobei die Isolierschichten (16,18) an den gegenüberliegenden Oberflächen einer Ablöseschicht (20) befestigt sind, deren Abmessungen denen der Isolierschichtränder nicht entsprechen, so dass ein Verbundmaterial-Schichtträger (10) entsteht;
Bildgeben und Ätzen der Leiterschichten zur Bildung von Leitermustern (22);
Einschneiden des Verbundmaterial-Schichtträgers an einem Punkt innerhalb seiner Ränder und in die Ablöseschicht;
Trennen der beiden mit Bild versehenen und geätzten Leiterschichten und Entfernen des Ablösematerials von der Isolierschicht.

2. Verfahren zur Herstellung von Leiterplatten mit starren und biegsamen Abschnitten nach Anspruch 1, wobei das Ablösematerial Poly(vinylfluorid) ist.

3. Verfahren zur Herstellung von Leiterplatten mit starren und biegsamen Abschnitten nach Anspruch 1, wobei die Isolierschichten aus mit einem Epoxidkleber imprägnierten Glasfaserschichten bestehen.

4. Verfahren zur Herstellung von Leiterplatten nach Anspruch 1, das folgende zusätzliche Schritte umfaßt:
Auflaminieren eines Paares aus ersten, mit einem Kleber imprägnierten Isolierschichten mit ausgeschnittenen Stellen und auf einer Seite mit einer Klebeschicht bedeckten Isolierlagen, deren Abmessungen denen der ausgeschnittenen Stellen entsprechen und die mindestens einen Rand der ersten Isolierschichten leicht überlappen, auf die abgetrennte, mit einem Bild versehene und geätzte Leiterschicht, so dass eine erste Leiterplattenstruktur mit einer Leiterschicht entsteht, Einschneiden passender biegsamer Kabel in die Fläche der ausgeschnittenen Stelle, Aufeinanderstapeln einer Vielzahl der ersten Leiterplattenstrukturen und von zweiten, mit einem Klebstoff imprägnierten Isolierschichten zwischen den ersten Leiterplattenstrukturen, wobei die zweiten Isolierschichten ausgeschnittene Stellen aufweisen, deren Abmessungen im wesentlichen mit denen der Isolierlagen übereinstimmen, Aufeinanderlaminieren der ersten Leiterplattenstrukturen und der zweiten Isolierschichten zur Bildung einer zweiten Leiterplattenstruktur mit starren und biegsamen Abschnitten, Bohren von Löchern in den starren Abschnitt der Leiterplattenstruktur, Reinigen der Bohrungen sowie Durchmetallisieren der Bohrungen zur Bildung leitender Zylinder, die die Leiter in den Leitermustern der Leiterschichten verbinden, wobei die zweite Leiterplattenstruktur eine starre und biegsame Abschnitte aufweisende Schaltung mit biegsamen Kabeln ist, die aus den mit den ausgeschnittenen Stellen größenmäßig übereinstimmenden Flächen herausgeschnitten sind und aus dem starren Abschnitt herausragen.

5. Verfahren nach Anspruch 4, wobei die Isolierlagen in dem starren Abschnitt mit einem Epoxidkleber imprägnierte Glasfaserschichten und die auf einer Seite mit einer Klebeschicht bedeckten Isolierlagen auf einer Seite mit einem Acrylkleber bedeckte Polyimidfolien sind.

6. Verfahren nach Anspruch 5, wobei die auf einer Seite mit einem Klebstoff imprägnierten Isolierlagen durch eine Lötmaske ersetzt werden, die bei Lichteinwirkung ein Bild erzeugt.

7. Verfahren nach Anspruch 1, das folgende weitere Schritte umfaßt:
Auflaminieren eines Paares aus ersten, mit einem Klebstoff imprägnierten Leiterschichten mit ausgeschnittenen Stellen und auf einer Seite mit einer Klebeschicht bedeckten Isolierlagen, deren Abmessungen denen der ausgeschnittenen Stelle entsprechen und die mindestens einen Rand der ersten Isolierflächen leicht überlappen, auf die mit einem Bild versehene und geätzte Leiterschicht, so dass eine erste Leiterplattenstruktur mit einer Leiterschicht entsteht, Einschneiden eines passenden biegsamen Kabels in die Fläche der ausgeschnittenen Stelle, Aufeinanderstapeln einer Vielzahl der ersten Leiterplattenstrukturen und von zweiten, mit einem Klebstoff imprägnierten Isolierschichten zwischen den ersten Leiterplattenstrukturen, wobei die zweiten Isolierschichten ausgeschnittene Stellen aufweisen, deren Abmessungen im wesentlichen mit denen der Isolierlagen übereinstimmen, Aufeinanderlaminieren der ersten Leiterplattenstrukturen und der Isolierschichten zur Bildung einer zweiten Leiterplattenstruktur mit starren und biegsamen Abschnitten, Bohren von Löchern in den starren Abschnitt der Leiterplattenstruktur, Reinigen der Bohrungen und Durchmetallisieren der Bohrungen zur Bildung leitender Zylinder, die die Leiter in den Leitermustern der Leiterschichten verbinden, wobei die zweite Leiterplattenstruktur eine starre und biegsame Abschnitte aufweisende Schaltung mit biegsamen Kabeln ist, die aus den mit den ausgeschnittenen Stellen größenmäßig übereinstimmenden Flächen herausgeschnitten sind und aus dem starren Abschnitt herausragen.

8. Verfahren nach Anspruch 7, wobei die Isolierlagen in dem starren Abschnitt um mit einem Epoxidkleber imprägnierte Glasfaserschichten und die auf einer Seite mit einer Klebeschicht bedeckten Isolierlagen in dem biegsamen Abschnitt Polyimidfolien mit Acrylkleberschichten sind.

9. Verfahren nach Anspruch 8, wobei die auf einer Seite mit einer Klebeschicht bedeckten Isolierlagen durch eine Lötmaske ersetzt werden, die bei Lichteinwirkung ein Bild erzeugt.

10. Verfahren nach Anspruch 1, das folgende weitere Schritte umfaßt:
Auflaminieren zweier erster Schichten aus dem Isoliermaterial des starren Abschnitts, bei denen jeweils eine Stelle entfernt ist, so dass ein Ausschnitt entsteht, der der biegsam zu machenden Fläche der Leiterplatte entspricht, sowie von zwei Lagen aus dem Isoliermaterial des biegsamen Abschnitts, die größenmäßig mit den Ausschnitten in den Isolierschichten des starren Abschnitts übereinstimmen und die jeweilige Isolierschicht des starren Abschnitts am Rand des darin befindlichen Ausschnitts leicht überlappen, auf die mit einem Bild versehene und geätzte Leiterschicht, so dass eine erste Leiterplattenstruktur mit einer Leiterschicht entsteht;
Einschneiden der Lagen aus dem Material des biegsamen Abschnitts und der ersten Isolierschicht zur Bildung mindestens eines biegsamen Kabels, das zumindest teilweise den Abmessungen der Ausschnitte in den Isolierschichten des starren Abschnitts entspricht.

11. Verfahren zur Herstellung von Leiterplatten nach Anspruch 10, wobei das Verfahren folgende weitere Schritte umfaßt:
Aufeinanderstapeln einer Vielzahl der ersten Leiterplattenstrukturen mit einer eingeschobenen Schicht aus dem Isoliermaterial des starren Abschnitts, die so positioniert ist, dass sie der Fläche der weiter zu laminierenden starren Abschnitte entspricht;
Aufeinanderlaminieren der Vielzahl von gestapelten ersten Leiterplattenstrukturen und der eingeschobenen Isolierschichten zur Bildung einer zweiten Leiterplattenstruktur mit starren und biegsamen Abschnitten;
Bohren von Löchern in die starren Abschnitte der zweiten Leiterplattenstruktur; und
Durchmetallisierung der Bohrungen zur Bildung leitender Zylinder, die die Leiter in den Leitermustern verbinden.

12. Verfahren zur Herstellung von Leiterplatten nach Anspruch 10, wobei es sich bei dem Isoliermaterial des starren Abschnitts um mit einem wärmeaktivierbaren Epoxidkleber imprägnierte Glasfasern und bei dem Isoliermaterial des biegsamen Abschnittes um eine auf einer Seite mit einem Acrylkleber bedeckte Polyimidfolie handelt.

13. Verfahren nach Anspruch 12, wobei die auf einer Seite mit einer Klebeschicht bedeckten Isolierlagen durch eine Lötmaske ersetzt sind, die bei Lichteinwirkung ein Bild erzeugt.

14. Verbundmaterial-Schichtträger für gedruckte Schaltungen mit starren und biegsamen Abschnitten, der die Herstellung zweier Leiterplatten mit starren und biegsamen Abschnitten ermöglicht, die nach der Bildgebung in zwei einzelne Verbundmaterial-Schichtträger getrennt werden können, der folgendes umfaßt:
zwei jeweils auf die entgegengesetzten Oberflächen zweier Isolierschichten laminierte Leiterschichten (12,14), wobei die Isolierschichten (16, 18) an den gegenüberliegenden Oberflächen einer Ablöseschicht (20) befestigt sind, deren Abmessungen nicht denen der Isolierschichtränder entsprechen, so dass ein Verbundmaterial-Schichtträger entsteht;
durch Bildgebung und Ätzen der Leiterschichten gebildete Leitermuster, wobei das Verbundmaterial an einem Ort innerhalb seiner Ränder und in die Ablöseschicht eingeschnitten werden kann und anschließend
die beiden mit einem Bild versehenen und geätzten Leiterschichten voneinander getrennt werden können und das Ablösematerial von den Isolierschichten entfernt werden kann.

15. Verbundmaterial-Schichtträger mit starren und biegsamen Abschnitten nach Anspruch 14, wobei die Ablöseschicht Poly(vinylfluorid) ist.

16. Verbundmaterial-Schichtträger mit starren und biegsamen Abschnitten nach Anspruch 14, wobei die Isolierschichten mit einem Epoxidkleber imprägnierte Glasfaserschichten sind.

## Revendications

1. Procédé de fabrication d'un circuit imprimé rigide/souple, comprenant les étapes consistant à
déposer une paire de couches conductrices (12, 14) sur les surfaces respectives opposées d'une paire de couches isolantes, dans lequel les couches isolantes (16, 18) sont fixées sur les surfaces opposées d'une couche de libération (20) et dans lequel ladite couche de libération ne s'étend pas en commun avec les limites des couches isolantes, de manière à former un composite d'approvisionnement de base (10) ;
former l'image et graver lesdites couches conductrices pour former des motifs conducteurs (22) ;
découper le composite d'approvisionnement de base en un point interne aux limites dudit composite et dans la couche de libération ;
séparer les deux couches conductrices sur lesquelles on a formé l'image et qui ont été gravée et éliminer ledit matériau de libération de la couche isolante.

2. Procédé pour la fabrication de cartes de circuits imprimés rigides/souples selon la revendication 1, dans lequel ledit matériau de libération est du poly(fluorure de vinyle).

3. Procédé pour la fabrication de cartes de circuits imprimés rigides/souples selon la revendication 1, dans lequel les couches isolantes sont des couches de fibres de verre imprégnées d'une colle époxy.

4. Procédé pour la fabrication de cartes de circuits selon la revendication 1, comprenant les étapes supplémentaires consistant à
déposer sur ladite couche conductrice sur laquelle on a formé l'image et qui a été gravée une paire de premières couches isolantes imprégnées d'une colle comportant des parties de découpe et
isoler les feuilles recouvertes d'un côté avec une couche adhésive s'étendant en commun avec la partie de découpe et recouvrant légèrement au moins un bord des premières couches isolantes de manière à former une première structure de circuit imprimé contenant une couche conductrice, découper des câbles souples convenables dans la zone de la partie de découpe, empiler une pluralité des premières structures imprimées avec des deuxièmes couches isolantes imprégnées d'une colle intercalée entre ladite première structure de circuit, les deuxièmes couches isolantes comportant des sections de découpe s'étendant de façon générale en commun avec les feuilles isolantes, déposer les premières structures de circuit imprimé et les deuxièmes couches isolantes ensemble de manière à former une deuxième structure de circuit imprimé comportant des parties rigides et souples, percer des trous dans la section rigide de la structure de circuit imprimé, nettoyer les trous et métalliser les trous de manière à former des barres conductrices reliant les conducteurs dans les motifs conducteurs des couches conductrices, de façon que la deuxième structure de circuit imprimé soit un circuit rigide/souple comportant des câbles souples découpés à partir des zones s'étendant en commun avec les parties de découpe et s'étendant depuis la section rigide.

5. Procédé selon la revendication 4, dans lequel les feuilles isolantes dans la section rigide sont des couches de fibre de verre imprégnées d'une colle époxy et les feuilles isolantes recouvertes d'un côté d'une couche adhésive sont des couches de films de polyimide recouvertes sur un côté par une colle acrylique.

6. Procédé selon la revendication 5, dans lequel les feuilles isolantes revêtues d'un côté par une colle sont remplacées par un masque de soudure pouvant recevoir une image photo.

7. Procédé selon la revendication 1, comprenant les étapes supplémentaires consistant à
déposer sur la couche conductrice sur laquelle on a formé l'image et qui a été gravée une paire de premières couches conductrices imprégnées d'une colle comportant des parties de découpe et des feuilles isolantes revêtues sur un côté d'une couche adhésive s'étendant en commun avec la partie de découpe et recouvrant légèrement au moins un bord des premières zones isolantes, de manière à former une première structure de circuit imprimé contenant une couche conductrice, découper un câble souple convenable dans la zone de la partie de découpe, empiler une pluralité des premières structures de circuit imprimé avec des deuxièmes couches isolantes imprégnées d'une colle intercalée entre lesdites premières structures de circuit, les deuxièmes couches isolantes comportant des sections de découpe s'étendant généralement en commun avec les feuilles isolantes, déposer les premières structures de circuit imprimé et les couches isolantes ensemble de manière à former une deuxième structure de circuit imprimé comportant une section rigide et souple, percer des trous dans la section rigide de la structure de circuit imprimé, nettoyer les trous et métalliser les trous de manière à former des barres conductrices reliant les conducteurs dans les motifs conducteurs des couches conductrices, de façon que la deuxième structure de circuit imprimé soit un circuit rigide/souple comportant des câbles souples découpés à partir des zones s'étendant en commun avec les parties de découpe et s'étendant à partir de la section rigide.

8. Procédé selon la revendication 7, dans lequel les feuilles isolantes dans la section rigide sont des couches de fibre de verre imprégnées d'une colle époxy et les feuilles isolantes recouvertes d'un côté par une couche adhésive dans la section souple sont des couches de films de polyimide comportant des couches de colle acrylique.

9. Procédé selon la revendication 8, dans lequel les feuilles isolantes recouvertes sur un côté avec une couche adhésive sont remplacées par un masque de soudure pouvant recevoir une image photo.

10. Procédé selon la revendication 1, comprenant en outre les étapes consistant à :
déposer sur la couche conductrice sur laquelle on a formé l'image et qui a été gravée une première paire de couches d'un matériau isolant de section rigide, comportant chacune une partie éliminée de celle-ci pour former une découpe qui correspond à la zone de carte de circuit destinée à être rendue souple, une paire de feuilles d'un matériau isolant de section souple s'étendant en commun avec les découpes dans les couches isolantes de section rigide et recouvrant légèrement une couche isolante de section rigide respective sur un bord de la découpe dans celle-ci, de manière à former une première structure de circuit imprimé contenant une couche conductrice ;
découper les feuilles de matériau de section souple et la première couche isolante de manière à former au moins un câble souple s'étendant en commun au moins partiellement avec les découpes dans lesdites couches isolantes de section rigide.

11. Procédé de fabrication de cartes de circuits imprimés selon la revendication 10, et dans lequel ledit procédé comporte les étapes supplémentaires consistant à :
empiler une pluralité desdites premières structures de circuit avec une couche intercalée d'un matériau isolant de section rigide positionnée de manière à s'étendre en commun avec les sections rigides destinées à être ultérieurement des sections rigides déposées ;
déposer ladite pluralité desdites premières structures de circuit imprimé empilées et des couches isolantes intercalées de manière à former une deuxième structure de circuit imprimé comportant des sections rigides et souples ;
percer des trous dans les sections rigides desdites deuxième structure de circuit imprimé ; et
métalliser lesdits trous de manière à former des barres conductrices reliant les conducteurs dans les motifs conducteurs.

12. Procédé de fabrication de cartes de circuits selon la revendication 10, dans lequel ledit matériau isolant de section rigide est de la fibre de verre imprégnée d'une colle époxy pouvant être activée thermiquement, et ledit matériau isolant de section souple est un film de polyimide revêtu sur un côté d'une colle acrylique.

13. Procédé selon la revendication 12, dans lequel les feuilles isolantes recouvertes d'un côté d'une couche adhésive sont remplacées par un masque de soudure pouvant recevoir une image photo.

14. Composite d'approvisionnement de base de circuit imprimé rigide/souple permettant la préparation de deux cartes de circuit rigide/souple pouvant être séparées en deux composites d'approvisionnement de base individuels, après formation d'image, comprenant
une paire de couches conductrices (12, 14) déposées sur les surfaces opposées respectives d'une paire de couches isolantes, dans lequel les couches isolantes (16, 18) sont fixées sur les surfaces opposées d'une couche de libération (20) et dans lequel ladite couche de libération ne s'étend pas en commun avec les limites des couches isolantes, de manière à former un composite d'approvisionnement de base ;
des motifs conducteurs formés par formation d'image et gravure desdites couches conductrices, le composite convenant pour être découpé en un point interne aux limites dudit composite et dans la couche de libération et pour ensuite séparer les deux couches conductrices sur lesquelles on a formé l'image et qui ont été gravées, et éliminer ledit matériau de libération des couches isolantes.

15. Composite d'approvisionnement de base rigide/souple selon la revendication 14, dans lequel la couche de libération est du poly(fluorure de vinyle).

16. Composite d'approvisionnement de base rigide/souple selon la revendication 14, dans lequel les couches isolantes sont des couches de fibre de verre imprégnées d'une colle époxy.
